# EUROPEAN PATENT APPLICATION

(11) **EP 3 734 310 A1**
(43) Date of publication of application: **04.11.2020**
(21) Application number: 18897418.2
(22) Date of filing: 26.12.2018
(51) Int. Cl.: G01R 31/40

(54) **POWER MONITORING METHOD, SYSTEM AND POWER SUPPLY**

(30) Priority: 27.12.2017 CN 201711447280
(71) Applicant: ZTE Corporation, Shenzhen, Guangdong 518057 (CN)
(72) Inventor: MENG, Yanni, Shenzhen, Guangdong 518057 (CN); DU, Yonghong, Shenzhen, Guangdong 518057 (CN); GENG, Jianbo, Shenzhen, Guangdong 518057 (CN)
(74) Representative: Aipex B.V.
(86) International application number: PCT/CN2018/123692
(87) International publication number: WO 2019/129016

(57) **Abstract**

Provided are a power monitoring method, a system and a power supply. The method includes the following steps: a parameter of an internal circuit to be monitored in a power supply is detected; a performance-index monitoring value of the internal circuit is determined according to a detection result; a deviation between the performance-index monitoring value and a performance-index standard value is determined; and a state of the internal circuit is determined according to the deviation.

## Description

The present application claims priority to Chinese patent application No. 201711447280.0 filed on December 27, 2017 to the CNIPA, the content of which is incorporated herein by reference in its entirety.

### TECHNICAL FIELD

The present application relates to power supplies and, for example, to a power monitoring method, a system and a power supply.

### BACKGROUND

With the development of communication technologies, communication is more and more important, and the power reliability of a power supply of communication equipment is particularly important. Therefore, requirements of a communication power supply on power management have become more and more demanding. It is necessary to monitor various data of the power supply and apply the data to the power management and even reliability protection. With the rapid development of communication traffic, requirements on the power capacity of the power supply have increasingly become demanding. Meanwhile, in view of requirements on energy conservation and environmental protection, the load capacity of the power supply is basically in a saturation interval with a heavy load. Such operating mode can greatly improve the efficiency of the power supply, but also implies higher risks. When the performance of the power supply degrades or the power supply has a slight fault, which has a certain impact on the output capacity, this operating mode will bring hidden dangers to the power for the load. For example, when a slow start circuit of the power supply is abnormal, a great voltage drop may be caused when a current flows through parallel resistors that limit an inrush starting current, so that the power supply cannot start or the limited current cannot power the rated load.

In the related art, in a process of the power monitoring, some parameters of the power supply are usually detected, and an alarm determination about the operating state or the control for the power supply is performed according to detection data of these parameters. During the operation, the alarm occurs if the data is abnormal and the alarm disappears if the data returns to normal. This monitoring mode cannot effectively monitor the degradation of the performance of the power supply.

### SUMMARY

The following is a summary of the subject matter described in detail herein. This summary is not intended to limit the scope of the claims.

An embodiment of the present application provides a power monitoring method. The method includes the following steps: a parameter of an internal circuit to be monitored in a power supply is detected, a performance-index monitoring value of the internal circuit is determined according to a detection result, and a deviation between the performance-index monitoring value and a performance-index standard value is determined; and a state of the internal circuit is determined according to the deviation.

An embodiment of the present application further provides a power supply. The power supply includes a monitoring apparatus and an internal circuit to be monitored. The monitoring apparatus includes a parameter detection module, a deviation calculation module and a state determination module. The parameter detection module is configured to detect a parameter of the internal circuit, and determine a performance-index monitoring value of the internal circuit according to a detection result. The deviation calculation module is configured to determine a deviation between the performance-index monitoring value and a performance-index standard value. The state determination module is configured to determine a state of the internal circuit according to the deviation.

The monitoring apparatus includes the parameter detection module, the deviation calculation module and the state determination module. The parameter detection module is configured to detect the parameter of the internal circuit to be monitored in the power supply, and determine the performance-index monitoring value of the internal circuit according to the detection result. The deviation calculation module is configured to determine the deviation between the performance-index monitoring value and the performance-index standard value. The state determination module is configured to determine the state of the internal circuit according to the deviation.

An embodiment of the present application further provides a power monitoring apparatus. The power monitoring apparatus includes a memory, a processor and a computer program stored in the memory and executable on the processor. The processor, when executing the computer program, implements the processing of the power monitoring method in the above embodiment of the present application.

An embodiment of the present application further provides a computer-readable storage medium. The computer-readable storage medium is configured to store a computer program. The computer program, when executed by a processor, implements the processing of the power monitoring method in the above embodiment of the present application.

Other aspects may be understood after the drawings and the detailed description are read and understood.

### BRIEF DESCRIPTION OF DRAWINGS

FIG. 1 is a flowchart of a power monitoring method according to embodiment one of the present application;
FIG. 2 is a structural diagram of a power supply according to embodiment one of the present application;
FIG. 3 is a block diagram of a monitoring apparatus according to embodiment one of the present application;
FIG. 4 is a schematic diagram illustrating circuits and the arrangement of detection points in a power supply according to embodiment two of the present application;
FIG. 5 is a graph illustrating a standard curve group of voltage drops of an input conditioning circuit according to embodiment two of the present application;
FIG. 6 is a flowchart of a power monitoring method according to embodiment two of the present application;
FIG. 7 is a graph illustrating a standard curve group of the efficiency of a power conversion circuit according to embodiment three of the present application;
FIG. 8 is a flowchart of a power monitoring method according to embodiment three of the present application;
FIG. 9 is a schematic diagram of a power supply circuit according to embodiment four of the present application;
FIG. 10 is a schematic diagram of a power supply circuit according to embodiment five of the present application; and
FIG. 11 is a schematic diagram of a power supply circuit according to embodiment six of the present application.

### DETAILED DESCRIPTION

The embodiments of the present application will be described in detail hereinafter with reference to the drawings. It is to be noted that if not in collision, the embodiments and features therein in the present application may be arbitrarily combined with each other.

### Embodiment one

In the related art, detection points are arranged for key devices in a power supply, and parameters of the detection points have different change trends, so that prediction may merely be performed on a single point. Such monitoring mode is insensitive to the degradation of the performance of an internal circuit in the power supply, so that the change of the performance of the internal circuit in the power supply cannot be effectively evaluated, and the degradation trend of the performance of the internal circuit in the power supply cannot be predicted. In this embodiment, instead of a detection and determination for an isolated parameter, multiple parameters obtained by detecting the internal circuit in the power supply are combined to calculate a performance index of the internal circuit, and then the state of the internal circuit is determined according to a deviation between a performance-index monitoring value and a performance-index standard value of the internal circuit, so that the change of the performance of the internal circuit in the power supply can be reflected, and the change of the performance of the power supply can be more accurately reflected.

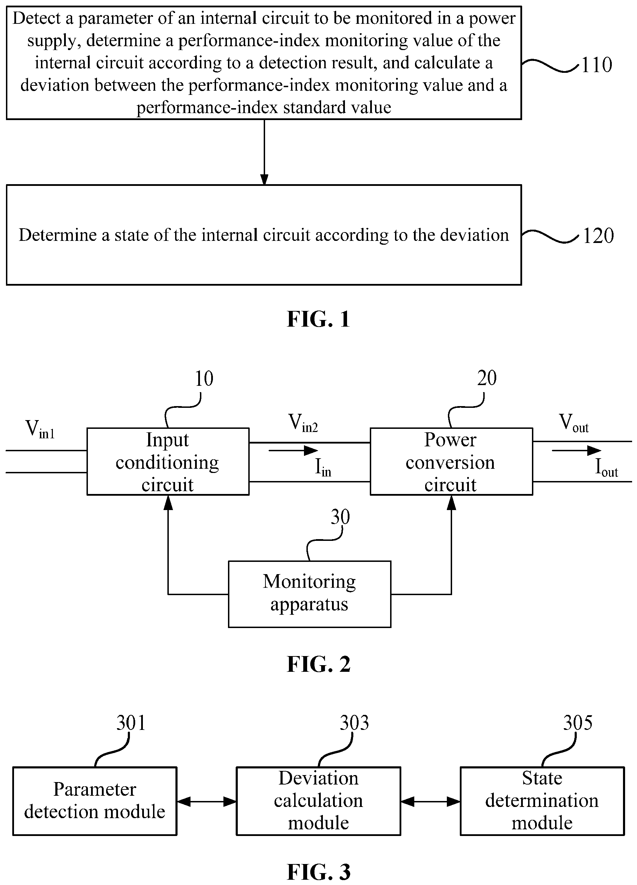

As shown in FIG. 1, this embodiment provides a power monitoring method. The method includes steps 110 and 120.

In step 110, a parameter of an internal circuit to be monitored in a power supply is detected, a performance-index monitoring value of the internal circuit is determined according to a detection result, and a deviation between the performance-index monitoring value and a performance-index standard value is determined.

In this embodiment, coupling relationships between related internal circuits in the power supply are closed, and at least one circuit for implementing at least one function is used as a functional circuit, and a circuit thereof includes at least one device. The performance of the functional circuit is monitored, and the degradation of the performance or the fault of the functional circuit may affect the overall performance and reliable operation of the power supply.

In this embodiment, the step in which the parameter of the internal circuit to be monitored in the power supply is detected includes the following step: an associated parameter of the performance-index standard value is detected. The performance-index standard value is determined in the following manner: searching, according to a parameter value obtained by detecting the associated parameter, information about a correspondence between the performance-index standard value and the parameter value of the associated parameter to obtain the performance-index standard value. In an example, the information about the correspondence has been corrected. For example, when the power supply operates in a system, a performance-index value corresponding to the parameter value of the associated parameter is tested, and initially stored information about the correspondence is corrected according to a test result. Generally, the initially stored information about the correspondence is obtained by testing some power supplies which are used as samples. Since single power supplies may have different features, when the internal circuit is monitored, the corrected information about the correspondence is used for searching for the performance-index standard value, which may more accurately reflect the features of the actually used power supply. Thus the state can be determined more effectively. In this example, the information about the correspondence may be represented by data of a standard curve group. However, the present application is not limited to this, and the information about the correspondence may be represented by another form of data.

In this embodiment, the deviation between the performance-index monitoring value and the performance-index standard value is represented by a deviation ratio. The deviation ratio is obtained by calculating a difference between the performance-index monitoring value and the performance-index standard value (the absolute value may be used or not used according to different performance indexes), and dividing the obtained difference by the performance-index standard value. However, in the present application, the deviation may also be represented in other manners. For example, the deviation may be directly represented by the difference between the performance-index monitoring value and the performance-index standard value.

In this embodiment, two types of functional circuits (also referred to as functional units), that is, an input conditioning circuit and a power conversion circuit, in the power supply are detected. The input conditioning circuit includes at least one type of circuits disposed between the power conversion circuit and an input end of the power supply. These circuits are generally used for implementing input protection and adjustment. In an example, the input conditioning circuit includes at least one of a lightning protection circuit, a slow start circuit, a multi-power redundancy configuration (Oring) circuit, an electro magnetic compatibility (EMC) filter circuit or an anti-reverse connection circuit. The present application is not limited to this, and the input conditioning circuit may include other circuits.

For the input conditioning circuit, in this embodiment, an input voltage and an output voltage of the input conditioning circuit are detected during the operation of the power supply, and a voltage-drop monitoring value of the input conditioning circuit is calculated according to a detection result. A voltage-drop standard value may change due to different factors such as a current and the temperature, so that at least one of the current or the temperature may be used as an associated parameter of the voltage-drop standard value. In this embodiment, both the current and the temperature are used as associated parameters, but in other embodiments, only one of the current or the temperature may be used as the associated parameter. In this embodiment, to determine the corresponding voltage-drop standard value more accurately, the temperature of an environment where the input conditioning circuit is located is detected while the parameter of the input conditioning circuit is detected. Information about a correspondence between the voltage-drop standard value, the current and the temperature of the input conditioning circuit is searched according to the detected current and the detected temperature to obtain the corresponding voltage-drop standard value, so that a deviation between the voltage-drop monitoring value and the corresponding voltage-drop standard value is determined.

In an example, the information about the correspondence between the voltage-drop standard value, the current and the temperature of the input conditioning circuit is represented by data of a standard curve group. When the power supply operates in the system for the first time, in view of the long-term load of the system, the environment of the system and other factors, a voltage drop value corresponding to the current and the temperature in rated conditions is tested. An initially stored standard curve group is corrected according to a test result. When the internal circuit in the power supply is monitored, the corrected standard curve group is used for searching for the corresponding voltage-drop standard value. A detection point of the current may be disposed at an output end or an input end of the input conditioning circuit, or inside the input conditioning circuit. The information about the correspondence between the voltage-drop standard value, the current and the temperature may also be represented by a correspondence between the voltage-drop standard value, the load and the temperature. That is, one associated parameter may be replaced by another associated parameter having a conversion relationship.

For the power conversion circuit, in this embodiment, an input voltage, an input current, an output voltage and an output current of the power conversion circuit are detected during the operation of the power supply, and an efficiency monitoring value of the power conversion circuit is calculated according to a detection result. An efficiency standard value fluctuates in a certain range due to changes of the input voltage and a load, so in this embodiment, to determine a deviation more accurately, the input voltage and the load are used as associated parameters of the efficiency. The efficiency standard value corresponding to the detected input voltage and the load (which may be calculated according to the detected output current and the detected output voltage) is determined according to information about a correspondence between the efficiency standard value, the input voltage and the load, and the deviation is calculated according to the efficiency monitoring value and the corresponding efficiency standard value. Similarly, the information about the correspondence between the input voltage, the load and the efficiency standard value may be represented by a correspondence between the efficiency standard value and another parameter having a conversion relationship.

In other embodiments, only one of the input voltage or the load may be used as the associated parameter.

In step 120, a state of the internal circuit is determined according to the deviation.

In this embodiment, the state of the internal circuit is determined according to the deviation in at least one of the following manners: in the case where the deviation falls into a deviation allowable range corresponding to a normal state, it is determined that the internal circuit is in the normal state; in the case where the deviation falls into a deviation alarm range corresponding to an alarm state, it is determined that the internal circuit is in the alarm state; or in the case where the deviation falls into a deviation fault range corresponding to a fault state, it is determined that the internal circuit is in the fault state.

When the state of the input conditioning circuit is determined, the corresponding deviation allowable range, deviation alarm range and deviation fault range refer to a deviation allowable range, deviation alarm range and deviation fault range set for the input conditioning circuit, respectively.

When the state of the power conversion circuit is determined, the corresponding deviation allowable range, deviation alarm range and deviation fault range refer to a deviation allowable range, deviation alarm range and deviation fault range set for the power conversion circuit, respectively.

In this embodiment, the degradation of the performance of the internal circuit is irreversible (that is, the degradation of the performance of the power supply is irreversible), so when the state of the internal circuit is determined according to the deviation, if the deviation is a deviation determined for the internal circuit for the first time or the deviation is greater than a basic deviation of the internal circuit, the state of the internal circuit is determined by using the deviation, and the deviation is stored as the basic deviation of the internal circuit; and if the deviation is not the deviation determined for the internal circuit for the first time and the deviation is less than or equal to the basic deviation of the internal circuit, the state of the internal circuit determined by using the basic deviation is maintained. Each time the deviation is determined, multiple calculations may be performed, and when the multiple calculations have a consistent result, the consistent result is used as the obtained deviation. This can avoid inaccurate detection values caused by the emergency, thereby avoiding an erroneous determination for the state of the internal circuit.

In this embodiment, after it is determined that the internal circuit (such as the input conditioning circuit, but not limited to this) is in the alarm state, if it is determined that the system where the power supply is located has multiple power supplies for powering, a current limit point of the power supply is automatically adjusted downward, and adjustment information about the current limit point is reported to the system, so that, in this embodiment, a function of power management is also included while the power monitoring is performed.

In this embodiment, after the detection result, the performance-index monitoring value, the deviation, and the state of the internal circuit are acquired, they may be reported to the system where the power supply is located. The system may be a power consumption system or a power supply system. These pieces of information may be reported separately or in various combinations.

In another embodiment, these pieces of information may be stored locally and extracted by the system where the power supply is located, or exported by a manager of the power supply.

In another embodiment, the power conversion circuit and the input conditioning circuit are used together as a functional circuit. The monitoring for the functional circuit is similar to the monitoring for the power conversion circuit, that is, an input voltage, an input current, an output voltage and an output current of the functional circuit are detected, and an efficiency monitoring value of the predefined circuit is calculated according to a detection result. The information about a correspondence between an efficiency standard value, the input voltage and the load of the predefined circuit is searched according to the detected input voltage and the load to obtain the efficiency standard value.

This embodiment further provides a power supply. As shown in FIG. 2, the power supply includes an input conditioning circuit 10, a power conversion circuit 20 and a monitoring apparatus 30. The input conditioning circuit 10 is configured to mainly complete functions such as input protection and includes at least one of a slow start circuit, an Oring circuit, an EMC filter circuit or an anti-reverse connection circuit. The power conversion circuit 20 is configured to complete power conversion. The power conversion circuit 20 may be built from discrete devices, or may be a power supply module. The monitoring apparatus 30 is configured to monitor the power supply, including the monitoring for the input conditioning circuit 10 and the power conversion circuit 20, report monitor information to the system where the power supply is located through a communication interface, and accept the control of the system.

As shown in FIG. 3, the monitoring apparatus includes a parameter detection module 301, a deviation calculation module 303 and a state determination module 305.

The parameter detection module 301 is configured to detect a parameter of the internal circuit to be monitor in the power supply, and determine a performance-index monitoring value of the internal circuit according to a detection result.

The deviation calculation module 303 is configured to determine a deviation between the performance-index monitoring value and a performance-index standard value.

The state determination module 305 is configured to determine a state of the internal circuit according to the deviation.

The parameter detection module 301 is a detection part of the monitoring apparatus and may be implemented by arranging detection points in the power supply. The deviation calculation module 303 and the state determination module 305 are a processing part of the monitoring apparatus 30, and may be implemented through independent chips in the power supply, or may be integrated into functional circuits in the power supply, for example, may be implemented through chips in the power conversion unit 20, which is not limited in this application.

In this embodiment, the internal circuit includes an input conditioning circuit.

The parameter detection module is configured to detect an input voltage and an output voltage of the input conditioning circuit, and calculate a voltage-drop monitoring value of the input conditioning circuit according to a detection result.

The deviation calculation module is configured to determine a deviation between the voltage-drop monitoring value and a corresponding voltage-drop standard value.

In this embodiment, the parameter detection module detecting the parameter of the internal circuit to be monitored in the power supply may be that the parameter detection module is configured to detect an associated parameter of the performance-index standard value.

The performance-index standard value is determined in the following manner: searching, according to a parameter value obtained by detecting the associated parameter, information about a correspondence between the performance-index standard value and the parameter value of the associated parameter to obtain the performance-index standard value.

The information about the correspondence may be obtained in the following manner: after the power supply is powered up and operates in the system, detecting a performance-index standard value corresponding to the parameter value of the associated parameter, correcting initially stored information about the correspondence according to a detection result, and searching for the performance-index standard value by using the corrected information about the correspondence.

In this embodiment, the parameter detection module detecting the parameter of the internal circuit to be monitored in the power supply may be that the parameter detection module is further configured to detect a current of the input conditioning circuit, and a temperature of an environment where the input conditioning circuit is located.

The state determination module is configured to determine the performance-index standard value in the following manner: searching information about a correspondence between a voltage-drop standard value, the current and the temperature of the input conditioning circuit according to the detected current and temperature to obtain the corresponding voltage-drop standard value.

In this embodiment, the internal circuit includes a predefined circuit, and the predefined circuit includes at least a power conversion circuit.

The parameter detection module is configured to detect an input voltage, an input current, an output voltage and an output current of the predefined circuit, and calculate an efficiency monitoring value of the predefined circuit according to a detection result.

The deviation calculation module is configured to determine a deviation between the efficiency monitoring value and an efficiency standard value.

In this embodiment, the state determination module is configured to determine the performance-index standard value in the following manner: searching information about a correspondence between the efficiency standard value, the input voltage and a load of the predefined circuit according to the detected input voltage and the load to obtain the corresponding efficiency standard value.

In this embodiment, the state determination module is configured to: if the deviation is a deviation determined for the internal circuit for the first time or the deviation is greater than a basic deviation of the internal circuit, determine the state of the internal circuit by using the deviation, and store the deviation as the basic deviation of the internal circuit; and if the deviation is not the deviation determined for the internal circuit for the first time and the deviation is less than or equal to the basic deviation of the internal circuit, maintain the state of the internal circuit determined by using the basic deviation.

In this embodiment, the state determination module is configured to determine the state of the internal circuit according to the deviation in at least one of the following manners: in the case where the deviation falls into a deviation allowable range corresponding to a normal state, determining that the internal circuit is in the normal state; in the case where the deviation falls into a deviation alarm range corresponding to an alarm state, determining that the internal circuit is in the alarm state; or in the case where the deviation falls into a deviation fault range corresponding to a fault state, determining that the internal circuit is in the fault state.

In this embodiment, the state determination module determining the state of the internal circuit according to the deviation may be that the state determination module is configured to, in the case where the deviation falls into the corresponding deviation alarm range, determine that the internal circuit is in the alarm state.

The monitoring apparatus further includes a current-limit-point adjustment module. The current-limit-point adjustment module is configured to: after the state determination module determines that the internal circuit is in the alarm state, if it is determined that the system where the power supply is located has multiple power supplies for powering, or there is a margin in the power capacity of the power supply, automatically adjust a current limit point of the power supply downward and report adjustment information about the current limit point to the system.

In this embodiment, the monitoring apparatus further includes an information reporting module. The information reporting module is configured to: after acquiring monitoring data, report the monitoring data to the system where the power supply is located. The monitoring data includes information about at least one of the detection result, the performance-index monitoring value, the deviation, or the state of the internal circuit.

This embodiment further provides a power monitoring apparatus. The power monitoring apparatus includes a memory, a processor and a computer program stored in the memory and executable on the processor. The processor, when executing the computer program, implements the processing of the power monitoring method in this embodiment of the present application.

This embodiment further provides a computer-readable storage medium. The computer-readable storage medium is configured to store a computer program. The computer program, when executed by a processor, implements the processing of the power monitoring method in this embodiment of the present application.

In this embodiment, the performance-index monitoring value of the internal circuit is determined and obtained according to the detection result of the parameter of the internal circuit, the change of the state of the internal circuit is determined according to the deviation between the performance-index monitoring value and the performance-index standard value. In this way, the degradation of the internal circuit, that is, the degradation of the power supply can be timely sensed, thus the safety of the usage of the power supply is improved. Furthermore, a trend prediction can also be performed. For example, according to changes in the degradation of the performance of the functional circuit as the time, it is predicted when the power supply will reach the fault state, or when the power supply will not be able to provide a sufficient load capacity, or the like.

### Embodiment two

This embodiment mainly describes the monitoring for an input conditioning circuit.

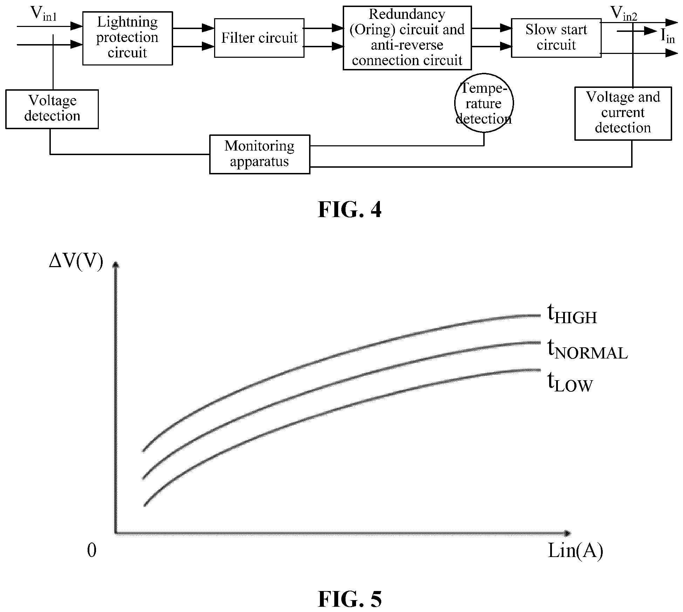

In this embodiment, a system where a power supply is located is powered by multiple direct current (DC) customized power supplies. As shown in FIG. 4, in the power supply, a lightening protection circuit, a filter circuit, an Oring circuit, an anti-reverse connection circuit and a slow start circuit constitute the input conditioning circuit. The power supply further has a power conversion circuit (not shown in FIG. 4, and reference may be made to FIG. 2). A control chip in the power conversion circuit completes the digital control of the conversion circuit and has a processing function of a monitoring apparatus. The monitoring apparatus 30 is configured to monitor the input conditioning circuit and the power conversion circuit, report monitoring data to the system where the power supply is located through a communication interface, and accept the control of the system.

Since the input conditioning circuit includes many circuits used for implementing various input protections, if detection points are separately arranged, a large Printed Circuit Board area is occupied. Moreover, these circuits are basically connected in series so that the link is affected if an abnormality occurs in one position. Therefore, these circuits are monitored as components of the input conditioning circuit. Usually, degradation or faults of these circuits may be reflected in a voltage drop of the input conditioning circuit. For example, if a drive of the Oring circuit is not turned on, when a current flows through a body diode, the voltage drop is increased to 0.7 V, and the heat loss of the diode is also increased. If there are Orings in both directions, the voltage drop is even doubled, so that the overall voltage drop of the input conditioning circuit is increased.

In this embodiment, before the monitoring is performed, detection points are arranged, a standard curve group is acquired, and threshold values used for state determination are set.

In this embodiment, the detection points arranged for the input conditioning circuit include an input voltage Vᵢₙ₁, an output voltage Vᵢₙ₂, a current Iᵢₙ, and a temperature detection point T. Positions of the detection points are as shown in FIG. 4. After the detection points are arranged, the input end voltage Vᵢₙ₁ of the input conditioning circuit and the output voltage Vᵢₙ₂ passing through the conditioning circuit may be detected. Vᵢₙ₂ is also the input voltage of the power conversion circuit (referring to FIG. 2). A state of the input conditioning circuit is determined by monitoring the voltage drop of the input conditioning circuit.

The standard curve group of the voltage drops of the input conditioning circuit is obtained through testing in a normal operating state of the power supply. During the testing, voltage drops ΔV_{instd} of the input conditioning circuit at different currents Iᵢₙ (the current Iᵢₙ corresponds to the load, and multiple currents Iᵢₙ may be acquired in light-load, half-load, full-load and other states) are respectively tested at a high temperature, a normal temperature and a low temperature (the corresponding temperature may be set according to operating conditions of the specific power supply). The standard curve group of the voltage drops of the input conditioning circuit is drawn and fitted, and the data is converted into an array form to be stored in the monitoring apparatus, so as to facilitate the look-up table and comparison during the operation of the power supply. FIG. 5 shows three standard curves, the abscissa is the input current Iᵢₙ, and the ordinate is the voltage drop ΔVᵢₙ between the input end and the output end of the input conditioning circuit, where ΔVᵢₙ = Vᵢₙ₁ - Vᵢₙ₂. The three standard curves are tested and obtained when the environment of the input conditioning circuit is located has three different temperatures t_{HIGH}, t_{NORMAL} and t_{LOW}.

The monitoring apparatus may store a standard curve group of the voltage drops of the input conditioning circuit obtained through testing previous power supply samples in advance, and then calibrate the stored standard curve group. When the power supply is powered up and operates normally in a power consumption system, an actual current, the temperature of the environment and the voltage drop of the input conditioning circuit are detected. The values of the detected current, temperature and voltage drop are compared with the voltage drop values corresponding to the current and the temperature in the corresponding standard curve to calibrate the standard curve. For example, the voltage drop values in the standard curve corresponding to the temperature and the current and the detected voltage drop values are weighted and averaged to obtain a standard curve matched with the actual application scenario. The preceding detection may be performed in different current and temperature conditions to integrally correct the standard curve group. The corrected standard curve group may be used during the monitoring.

Meanwhile, performance state determination threshold values are preset in the monitoring apparatus according to circuit conditions. The performance state determination threshold values include a performance state normal threshold value, a performance state alarm threshold value and a performance state fault threshold value. These threshold values may be used for determining voltage-drop value ranges corresponding to different states of the input conditioning circuit.

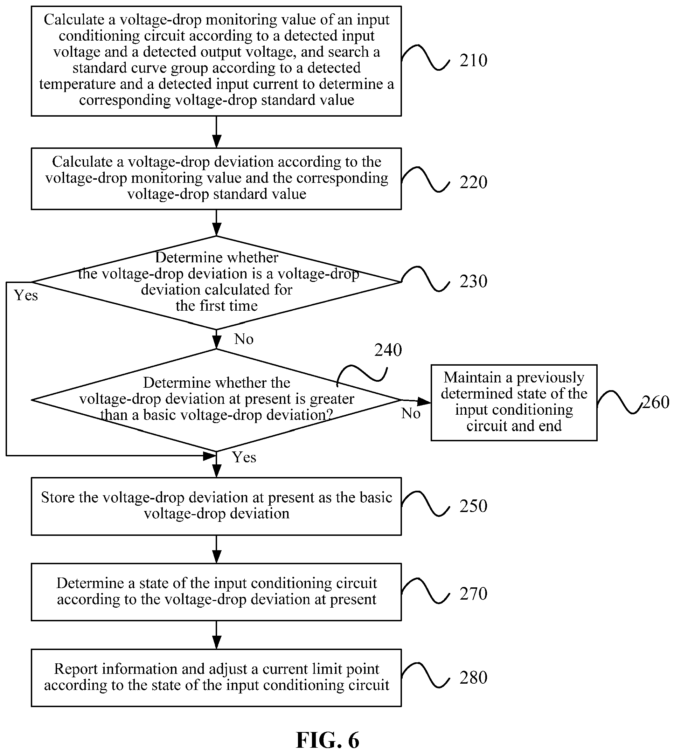

Referring to FIG. 6, during the operation of the power supply, the monitoring apparatus detects the input voltage, the output voltage, the input current and other parameters of the input conditioning circuit, acquires the temperature at present from a temperature detection point, and performs steps 210 to 280.

In step 210, a voltage-drop monitoring value of the input conditioning circuit is calculated according to the detected input voltage and output voltage, and the standard curve group is searched according to the detected temperature and input current to determine the corresponding voltage-drop standard value.

In this step, ΔVᵢₙ is calculated according to the detected Vᵢₙ₁ and Vᵢₙ₂, where ΔVᵢₙ here is referred to as the voltage-drop monitoring value. The temperature at present is detected through the temperature detection point arranged in the input conditioning circuit, a standard curve corresponding to the temperature at present is determined in the standard curve group (using the corrected standard curve group described above), and then the standard curve is searched according to the detected input current Iᵢₙ to obtain the corresponding voltage-drop standard value.

In step 220, the voltage-drop deviation at present is calculated according to the voltage-drop monitoring value and the corresponding voltage-drop standard value.

The voltage-drop deviation may be represented by a voltage-drop deviation ratio or a voltage-drop deviation value.

The detection and calculation in the two steps described above are performed many times, and subsequent processing is performed when the calculated voltage-drop deviations are consistent.

In step 230, it is determined whether the voltage-drop deviation at present is a voltage-drop deviation calculated for the first time; if the voltage-drop deviation at present is not the voltage-drop deviation calculated for the first time, step 240 is performed; and if the voltage-drop deviation at present is the voltage-drop deviation calculated for the first time, step 250 is performed.

In step 240, it is determined whether the voltage-drop deviation at present is greater than a basic voltage-drop deviation; if the voltage-drop deviation at present is less than or equal to the basic voltage-drop deviation, step 260 is performed; and if the voltage-drop deviation at present is greater than the basic voltage-drop deviation, step 250 is performed.

In step 250, the voltage-drop deviation at present is stored as the basic voltage-drop deviation, and then, step 270 is performed.

If the voltage-drop deviation at present is the voltage-drop deviation calculated for the first time, the voltage-drop deviation is stored and used as the basis for determining the state of the input conditioning circuit this time. If the voltage-drop deviation at present is not the voltage-drop deviation calculated for the first time, and the voltage-drop deviation calculated this time is greater than the stored basic deviation, the voltage-drop deviation calculated this time is stored as a new basic deviation and used as the basis for determining the state of the input conditioning circuit.

In step 260, a previously determined state of the input conditioning circuit is maintained, and the process ends.

Since the degradation of the input conditioning circuit is irreversible, the processing may not be performed in the case where the calculated voltage-drop deviation this time is less than or equal to the stored basic deviation.

In step 270, the state of the input conditioning circuit is determined according to the voltage-drop deviation at present.

In this step, when the state of the input conditioning circuit is determined according to the voltage-drop deviation, if the voltage-drop deviation falls into a performance state normal threshold value range (that is, a deviation allowable range of the voltage drop), it is determined that the input conditioning circuit is in a normal state and have good performance; if the voltage-drop deviation exceeds the performance state alarm threshold value and is less than the performance state fault threshold value, that is, the voltage-drop deviation falls into a deviation alarm range of the voltage drop, it is determined that the input conditioning circuit is in an alarm state and the performance of the input conditioning circuit degrades; and if the voltage-drop deviation exceeds the performance state fault threshold value, that is, the voltage-drop deviation falls into a deviation fault range of the voltage drop, it is determined that the input conditioning circuit is in a fault state, and the performance of the input conditioning circuit may seriously degrades or be abnormal, so the power supply needs to be maintained or replaced. The number of states and the number of deviation ranges described above are each not limited to three. In other embodiments, two, four or more deviation ranges may be set, and each deviation range corresponds to a respective state.

The state of the input conditioning circuit may be used as the state of the power supply. If there are multiple functional circuits in the power supply, the worst state among states of the multiple functional circuits may be used as the state of the power supply. Taking the preceding three states as an example, the alarm state is better than the normal state but worse than the fault state.

In this embodiment, the maximum value among the calculated voltage-drop deviations is stored as the basic deviation, and the state of the input conditioning circuit is determined according to the basic deviation. However, in other embodiments, the state of the input conditioning circuit may be determined according to the voltage-drop deviation calculated each time.

In step 280, information is reported and a current limit point is adjusted downward according to the state of the input conditioning circuit.

The monitoring apparatus may select different processing modes for the monitoring data according to backup signals related to the redundancy configuration of the power supply or according to configuration data of the power supply provided by the system. For example, at the beginning of the powered-up stage, the system may notify that the system where the power supply is located is configured with multiple power supplies (that is, there are multiple power supplies for powering) or configured with a single power supply.

Depending on whether the power supply supports the adjustment of the current limit point, the processing may be performed in the following modes.

Mode 1: In the case where the power supply does not support the adjustment of the current limit point, the processing logic is as described below.

If it is determined that the input conditioning circuit is in the normal state, the monitoring data may be reported.

If it is determined that the input conditioning circuit is in the alarm state, the monitoring data is reported to the system to perform the alarm of the performance degradation of the power supply, and the system adjusts the load of the power supply.

If it is determined that the input conditioning circuit is in the fault state, the monitoring data and the information that the performance of the power supply degrades into the fault state are reported, and the system determines whether to replace or maintain the power supply.

The above-mentioned monitoring data may be carried in an alarm message and the monitoring data and alarm information are reported, so as to facilitate the system to perform the background record and management.

Mode 2: In the case where the power supply supports the adjustment of the current limit point, the processing logic is as described below.

If it is determined that the input conditioning circuit is in the normal state, performance monitoring data may be reported. The performance monitoring data may be at least one of a detected parameter value, performance-index monitoring value, deviation, state or other data.

If it is determined that the input conditioning circuit is in the alarm state, it is determined whether the system where the power supply is located has multiple power supplies for powering.

If there are multiple power supplies for powering, the current limit point is automatically adjusted downward, and the monitoring data and adjustment information about the current limit point are reported to the system and the alarm of the performance degradation of the power supply is performed. The system may be informed of the monitoring data in an early warning mode.

If there are not multiple supplies for powering, it is determined whether there is a margin in the power capacity of the power supply. If there is a margin, the monitoring data is reported to the system and the alarm of the performance degradation of the power supply is performed, and the system may adjust the current limit point of the power supply downward and adjust the load of the power supply. If there is no margin, the monitoring data is reported to the system and the alarm of the performance degradation of the power supply is performed, and the system adjusts the load of the power supply.

If it is determined that the input conditioning circuit is in the fault state, the monitoring data and the information that the performance of the power supply degrades into the fault state are reported, and a maintainer determines whether to replace or maintain the power supply.

The current limit point being adjusted downward can reduce the power capacity of the power supply, that is, the maximum power that the power supply can provide, so that the current flowing through the input conditioning circuit is reduced, and created heat is decreased, thereby achieving the derating usage and safe operation.

In this embodiment, the monitoring apparatus monitors the input conditioning circuit, calculates the voltage-drop monitoring value of the input conditioning circuit according to the detected parameter value of the input conditioning circuit, and determines the deviation between the voltage-drop monitoring value and the corresponding voltage-drop standard value to determine the state of the input conditioning circuit. The change trend of the performance of the input conditioning circuit, for example, the downward trend of the load capacity, and the development trend of the voltage-drop degradation, may be predicted according to the change trend of the deviation to determine whether a maintenance operation such as replacement or an overhaul is performed on the power supply. In this way, the degradation or abnormity of the performance state of the power supply can be early warned so that the safety of the power supply is prevented from being affected by the degradation of the communication power supply. Moreover, the service life of the power supply can be prolonged by load reduction, the adjustment to the current limit point, and other measures.

### Embodiment three

This embodiment mainly describes the monitoring for a power conversion circuit.

A power supply circuit in this embodiment is shown in FIG. 2. The power conversion circuit in the power supply is implemented by a direct current/direct current (DC/DC) module. The DC/DC module completes a conversion from 48 V to 28 V. A control chip in the DC/DC module has the function of a monitoring apparatus and may communicate with a system. The power conversion circuit may be built from discrete devices, or may be a power supply module. The degradation is mainly considered for this part of the circuit to correct the power output that the power supply can provide. If devices in the power conversion circuit degrades or are damaged, the efficiency of the power conversion circuit is affected. For example, if a drive resistance of a switch transistor in the power conversion circuit becomes greater, the switch loss is increased, and the efficiency of the power conversion circuit is decreased, so the monitored performance index of the power conversion circuit is the efficiency in this embodiment.

Referring to FIG. 2, in the exemplary power supply, an input voltage of the power conversion circuit is an output voltage Vᵢₙ₂ of the input conditioning circuit, and an input current of the power conversion circuit is a current Iᵢₙ at an output end of the input conditioning circuit. Additionally, an output voltage Vₒᵤₜ and an output current Iₒᵤₜ of the power conversion circuit need to be detected.

Before the monitoring, corresponding detection points are arranged to detect the input voltage, the input current, the output voltage and the output current of the power conversion circuit.

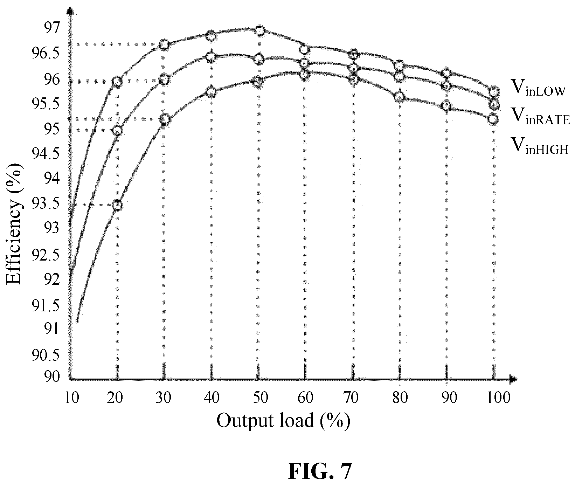

The monitoring apparatus may store a standard curve group of the efficiency of the power conversion circuit. In an example, the standard curve group of the efficiency of the power conversion circuit may be provided by a module power supply. The standard curve group includes efficiency curves in three conditions: an input voltage low limit V_{inLOW}, a rated input voltage V_{in RATE} and an input voltage high limit V_{inHIGH}. As shown in FIG. 7, the abscissa in FIG. 7 is the load (that is, the output load in FIG. 7), and the ordinate is the efficiency. When the power supply is applied to the system, the monitoring apparatus may detect an input voltage, an output load and an efficiency monitoring value of the application system at present after power-up for the first time, and compare the efficiency monitoring value with an efficiency standard value corresponding to the input voltage and the load at present in a corresponding standard curve to calibrate the standard curve. The preceding detection may be performed in different input voltage and output load conditions to integrally correct the standard curve group, and a standard curve group matched with the application scenario is stored. The data of the standard curve group may be converted into an array form to be stored in the monitoring apparatus, so as to facilitate the look-up table and comparison during the operation of the power supply.

In the monitoring apparatus, performance state determination threshold values of the power conversion circuit are preset according to circuit conditions. The performance state determination threshold values include a performance state normal threshold value, a performance state alarm threshold value and a performance state fault threshold value, and are represented by corresponding efficiency values.

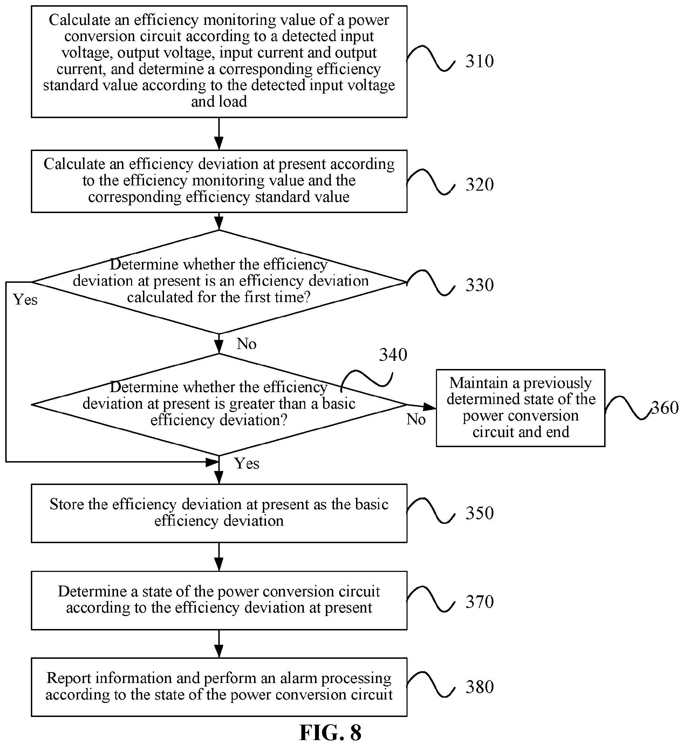

Referring to FIG. 8, the monitoring apparatus detects the input voltage, the output voltage, the input current, the output current and other parameters of the power conversion circuit, and performs steps 310 to 380.

In step 310, the efficiency monitoring value of the power conversion circuit is calculated according to the detected input voltage, output voltage, input current and output current, the standard curve group is searched according to the detected input voltage and load to determine a corresponding efficiency standard value.

In this step, the efficiency monitoring value of the power conversion circuit is calculated according to the detected Vᵢₙ₂, Iᵢₙ, Vₒᵤₜ and Iₒᵤₜ, the load at present (that is, the detected load) is calculated according to Vₒᵤₜ and Iₒᵤₜ, a standard curve corresponding to the input voltage Vᵢₙ₂ at present is determined in the standard curve group, and then, the standard curve is searched according to the load at present to obtain the corresponding efficiency standard value.

In step 320, an efficiency deviation at present is calculated according to the efficiency monitoring value and the corresponding efficiency standard value.

The efficiency deviation may be represented by an efficiency deviation ratio or an efficiency deviation value. The efficiency deviation value is a difference between the efficiency standard value and the efficiency monitoring value. The efficiency deviation ratio is equal to the ratio of the efficiency deviation value to the efficiency standard value.

The detection and calculation in the two steps described above are performed many times, and subsequent processing is performed when the calculated efficiency deviations are consistent.

In step 330, it is determined whether the efficiency deviation at present is an efficiency deviation calculated for the first time; if the efficiency deviation at present is not the efficiency deviation calculated for the first time, step 340 is performed; and if the efficiency deviation at present is the efficiency deviation calculated for the first time, step 350 is performed.

In step 340, it is determined whether the efficiency deviation at present is greater than a basic efficiency deviation; if the efficiency deviation at present is less than or equal to the basic efficiency deviation, step 360 is performed; and if the efficiency deviation at present is greater than the basic efficiency deviation, step 350 is performed.

In step 350, the efficiency deviation at present is stored as the basic efficiency deviation, and then, step 370 is performed.

If the efficiency deviation at present is the efficiency deviation calculated for the first time, the efficiency deviation is stored and used as the basis for determining the state of the power conversion circuit this time. If the efficiency deviation at present is not efficiency deviation calculated for the first time, and the efficiency deviation calculated this time is greater than the stored basic deviation, the efficiency deviation calculated this time is stored as a new basic deviation and used as the basis for determining the state of the power conversion circuit.

In step 360, a previously determined state of the power conversion circuit is maintained, and the process ends.

Since the degradation of the power conversion circuit is irreversible, the processing may not be performed in the case where the calculated efficiency deviation this time is less than or equal to the stored basic deviation.

In step 370, the state of the power conversion circuit is determined according to the efficiency deviation at present.

In this step, when the state of the power conversion circuit is determined according to the efficiency deviation, if the efficiency deviation falls into a performance state normal threshold value range (that is, a deviation allowable range of the efficiency), it is determined that the power conversion circuit is in a normal state and have good performance; if the efficiency deviation exceeds the performance state alarm threshold value and is less than the performance state fault threshold value, that is, the efficiency deviation falls into a deviation alarm range of the efficiency, it is determined that the power conversion circuit is in an alarm state, the performance of the power conversion circuit degrades, and the power capacity of the power supply needs to be corrected; if the efficiency deviation exceeds the performance state fault threshold value, that is, the efficiency deviation falls into a deviation fault range of the efficiency, it is determined that the power conversion circuit is in a fault state, and the performance of the power conversion circuit seriously degrades or is abnormal, so the power supply needs to be maintained or replaced. The number of states and the number of deviation ranges described above are each not limited to three. In other embodiments, two, four or more deviation ranges may be set, and each deviation range corresponds to a respective state.

In step 380, information is reported and an alarm processing is performed according to the state of the power conversion circuit.

If it is determined that the power conversion circuit is in the normal state, the monitoring data may be reported or not reported. If it is determined that the power conversion circuit is in the alarm state, the monitoring data is reported to the system and the alarm of the performance degradation of the power supply is performed. If it is determined that the power conversion circuit is in the fault state, the monitoring data and the information that the performance of the power supply degrades into the fault state are reported, and the system determines whether to replace or maintain the power supply.

In this embodiment, the monitoring apparatus monitors the power conversion circuit, calculates the efficiency monitoring value of the power conversion circuit according to the detected parameter of the power conversion circuit, and determines the deviation between the efficiency monitoring value and the corresponding efficiency standard value to determine the state of the power conversion circuit. The change trend of the efficiency of the power conversion circuit may be predicted according to the change trend of the deviation. In this way, the degradation or abnormity of the performance state of the power supply caused by the power conversion circuit can be early warned, and the safety of the usage of the power supply is improved.

In another embodiment, the input conditioning circuit is monitored by using the method in embodiment two, and the power conversion circuit is monitored by using the method in embodiment three. In the case where any one of the input conditioning circuit or the power conversion circuit is in the performance alarm state, or the performance of the any one of the input conditioning circuit or the power conversion circuit degrades into the fault state, the corresponding monitoring data, and alarm or fault information are reported to the system to assist the system in determining whether to replace or maintain the power supply. For the processing of the input conditioning circuit and the power conversion circuit in different states, reference is made to corresponding content of embodiments two and three.

### Embodiment four

In this embodiment, a power conversion circuit and an input conditioning circuit are regarded as a functional circuit, and the efficiency is used as a performance index of the functional circuit. An input voltage, an input current, an output voltage and an output current of the functional circuit are detected. An efficiency monitoring value of the functional circuit is calculated according to a detection result. A deviation between the efficiency monitoring value and a corresponding efficiency standard value is determined to determine a state.

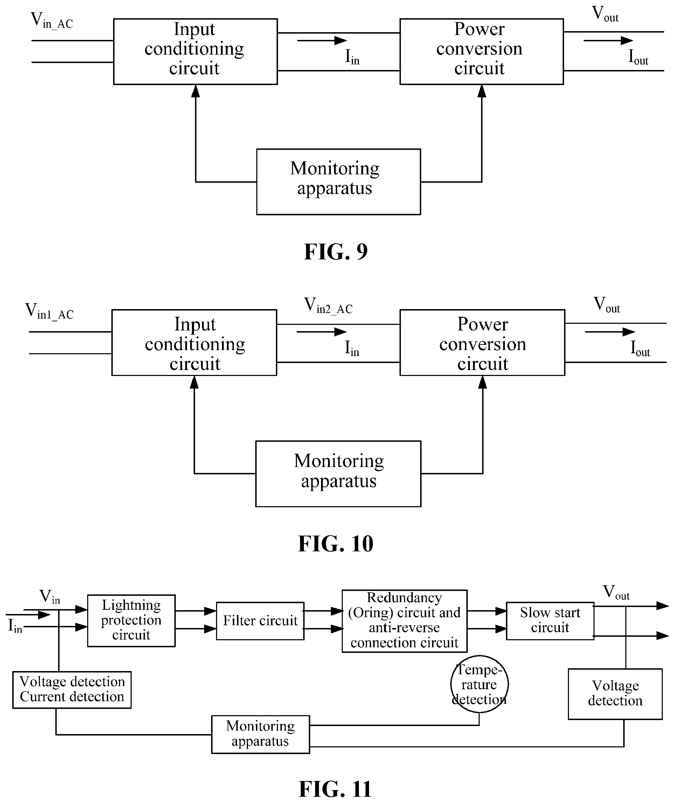

As shown in FIG. 9, a system in this embodiment is powered by multiple alternating current customized power supplies. An alternating current power supply has an alternating current/direct current (AC/DC) conversion circuit which completes a conversion from 220 V to 28 V and serves as a functional conversion circuit. The power conversion circuit has a digital signal processing (DSP) control chip which completes the digital control of the conversion circuit and has the function of the monitoring apparatus and performs inter-integrated circuit (IIC) communication with the system. Since an input current of the alternating current power supply is relatively small, and a voltage drop of the input conditioning circuit is relatively small, the functional circuit including the input conditioning circuit and the power conversion circuit is monitored in this example. The functional circuit is also referred to as a whole circuit, and the monitoring method for the whole circuit is similar to the monitoring method for the power conversion circuit.

In this embodiment, the monitoring method includes arrangement of detection points, storage of a standard curve group, monitoring for a state during the operation and application of monitoring data.

Arrangement of the detection points: Test points are arranged in the input conditioning circuit for an input voltage V_{in_AC} and a current Iᵢₙ, and the power conversion circuit is implemented by an integrated power supply module, so the test points are arranged to detect an output voltage Vₒᵤₜ and an output current Iₒᵤₜ of the module power supply.

Storage of the standard curve group: The standard curve group of the whole circuit efficiency of the power supply includes efficiency standard curves in three conditions: an input voltage low limit, a rated input voltage value and an input voltage high limit, and the data is converted into an array form to be stored in the monitoring apparatus, so as to facilitate the look-up table and comparison during the operation of the power supply. Meanwhile, performance state determination threshold values are preset in the monitoring apparatus according to circuit conditions and include a performance state normal threshold value, a performance state alarm threshold value and a performance state fault threshold value.

Monitoring for the state during the operation: The V_{in_AC}, Iᵢₙ, Vₒᵤₜ and Iₒᵤₜ are detected, and the efficiency monitoring value of the whole circuit is calculated; and the monitoring apparatus searches for a table corresponding to the efficiency standard curve group, compares the efficiency monitoring value with the found efficiency standard value, and calculates and records the efficiency deviation to determine the change trend of the efficiency of the whole circuit. When the state is determined, if the efficiency deviation falls into a performance state normal threshold value range, it is determined that the performance of the whole conditioning circuit is normal; if the efficiency deviation exceeds the performance state alarm threshold value and is less than the performance state fault threshold value, it is determined that the whole circuit is in an alarm state; if the efficiency deviation exceeds the performance state fault threshold value, it is determined that the whole circuit has been in a fault state. When the subsequent monitoring is performed, the stored efficiency deviations will be used as the basis, the maximum efficiency deviation thereof is selected to perform determination, and a basic deviation of the efficiency is updated.

Application of the monitoring data: The system in this embodiment is configured with multiple power supplies for powering, and at the beginning of the powered-up stage, the system notifies that the power supply system is configured with multiple power supplies through IIC communication. The monitoring apparatus performs processing according to a determination result of the state of the whole circuit such that: if the whole circuit is in the alarm state, the loop control is performed through the DSP, a current limit point of the power supply is automatically adjusted downward, the alarm of the performance of the power supply is performed, and the monitoring data and the information that the limit point at present is adjusted downward are reported to the system; if the whole circuit is in the fault state, the monitoring data and the information about the power supply performance fault are reported to the system to assist the system in analyzing whether to replace the power supply.

### Embodiment five

As shown in FIG. 10, a system is powered by multiple alternating current customized power supplies. An alternating current power supply has an AC/DC conversion circuit which completes a conversion from 220 V to 28 V and serves as a power conversion circuit. The power conversion circuit has a DSP control chip which completes the digital control of the conversion circuit, has the function of the monitoring apparatus and performs IIC communication with the system. Since an input current of the alternating current power supply is relatively small, a voltage drop of an input conditioning circuit is relatively small. The efficiency of the power conversion circuit is evaluated in this embodiment.

Arrangement of detection points: Test points are arranged at an output end of the input conditioning circuit to detect an output voltage V_{in2_AC} and a current Iᵢₙ. The power conversion circuit is implemented by an integrated power supply module. The test points are arranged to detect an output voltage Vₒᵤₜ and an output current Iₒᵤₜ of the module power supply.

Storage of a standard curve group: The standard curve group of the efficiency of the power conversion circuit includes efficiency curves in three conditions: an input voltage low limit, a rated input voltage value and an input voltage high limit, and the data is converted into an array form to be stored in the monitoring apparatus, so as to facilitate the look-up table and comparison during the operation of the power supply. Meanwhile, performance state determination threshold values are preset in the monitoring apparatus according to circuit conditions and include a performance state normal threshold value, a performance state alarm threshold value, and a performance state fault threshold value.

Monitoring for the state during the operation: The input voltage V_{in2_AC}, the input current Iᵢₙ and the output voltage Vₒᵤₜ and the output current Iₒᵤₜ of the power conversion circuit are detected, and an efficiency monitoring value is calculated; a table corresponding to the efficiency standard curve group is searched, the efficiency monitoring value is compared with an efficiency standard value, and an efficiency deviation is calculated and recorded to determine the change trend of the efficiency of the power conversion circuit. When the performance state is determined, if the efficiency deviation falls into a performance state normal threshold value range, it is determined that the power conversion circuit is in a normal state and; if the efficiency deviation exceeds the performance state alarm threshold value and is less than the performance state fault threshold value, it is determined that the power conversion circuit is in an alarm state; and if the efficiency deviation exceeds the performance state fault threshold value, it is determined that the power conversion circuit is in a fault state. When subsequent monitoring is performed, the stored efficiency deviations are used as the basis and the maximum efficiency deviation thereof is selected to perform determination.

Application of monitoring data: This process is the same as that in embodiment three.

### Embodiment six

In this embodiment, a system is powered by a single direct current power supply that has an input of 48 V and an output of 48 V. The power supply is a direct power supply, so the power supply merely has an input conditioning circuit and does not have a power conversion circuit. As shown in FIG. 11, the input conditioning circuit includes at least one of a lightening protection circuit, a filter circuit, an Oring circuit or a slow start circuit. The power supply uses a single chip microcomputer to monitor data and communicate with the system, and to serve as a monitoring apparatus.

Arrangement of detection points: Test points are arranged for an input voltage Vᵢₙ, an output voltage Vₒᵤₜ, an input current Iᵢₙ and a temperature test point T.

Storage of a standard curve group: The standard curve group of voltage drops of the input conditioning circuit is acquired through testing data of sample power supplies: the input voltage Vᵢₙ, the output voltage Vₒᵤₜ, the input current Iᵢₙ, the temperature test point T and the voltage drop ΔV_{instd}. The standard curve group includes data at a high temperature, a normal temperature and a low temperature. The states of the load of the power supply include light-load, half-load and full-load. The standard curve group of the voltage drops of the input conditioning circuit is drawn and fitted. Moreover, the data is converted into an array form to be stored in the monitoring apparatus, so as to facilitate the look-up table and comparison during the operation of the power supply. Meanwhile, performance state determination threshold values are preset in the monitoring apparatus according to circuit conditions and include a performance state normal threshold value, a performance state alarm threshold value, and a performance state fault threshold value.

Monitoring for the state during the operation: When the input conditioning circuit is monitored, the input voltage Vᵢₙ, the output voltage Vₒᵤₜ, the input current Iᵢₙ and the temperature T are detected, and a voltage-drop monitoring value of the input conditioning circuit is calculated; a table corresponding to the standard curve group of the voltage drops is searched, the voltage-drop monitoring value is compared with the found voltage-drop standard value, and a voltage-drop deviation is calculated and recorded. The performance state is determined as follows: if the voltage-drop deviation falls into a performance state normal threshold value range, it is determined that the performance of the power supply is in a normal state; if the voltage-drop deviation exceeds the performance state alarm threshold value and is less than the performance state fault threshold value, it is determined that the performance of the power supply is in an alarm state; and if the voltage-drop deviation exceeds the performance state fault threshold value, it is determined that the performance of the power supply has been in a fault state. When subsequent monitoring is performed, the stored voltage-drop deviations are used as the basis and the maximum voltage-drop deviation thereof is selected to perform determination.

Application of monitoring data: Since the system is configured with a single power supply for powering, at the beginning of the powered-up stage, the system notifies that the power supply system is configured with the single power supply through IIC communication and the power supply does not support the adjustment of a current limit point. If the determination result is that the performance of the power supply is in the alarm state and the function capability of the power supply has reached a rated value, the monitoring apparatus reports the monitoring data and the information about the power supply performance alarm to the system and the system adjusts the load. If the determination result is that the performance of the power supply is in the fault state, the monitoring apparatus reports the monitoring data and the information about the power supply performance fault to the system to assist the system in analyzing whether to replace the power supply.

By using the method and the system described in the embodiments of the present application, a performance state and the change of the performance state of an internal circuit in a power supply can be acquired, and a degradation trend of the performance of the power supply can be determined. A performance state of a key circuit can be predicted by parameter detection and performance calculation for a functional circuit without arranging many detection points and occupying too much Printed Circuit Board area. Additionally, a current limit point can be adjusted. Alternatively, information can be reported to a system, and the system complete operations such as adjustment of the load and the current limit point. In the case where the power supply degrades into a fault state, the system can be assisted in determining whether to replace the power supply, thereby ensuring the reliability of the operation of the system.

It is to be understood by those skilled in the art that functional modules/units in all or part of the steps of the method, the system and the apparatus disclosed above may be implemented as software, firmware, hardware and appropriate combinations thereof. In the hardware implementation, the division of the functional modules/units mentioned in the above description may not correspond to the division of physical components. For example, one physical component may have multiple functions, or one function or step may be performed jointly by several physical components. Some or all physical components are implemented as software executed by processors such as central processing units, digital signal processors or microcontrollers, or implemented as hardware, or implemented as integrated circuits such as specific integrated circuits. Such software may be distributed on a computer-readable medium. The computer-readable medium may include a computer storage medium (or a non-transitory medium) and a communication medium (or a transitory medium). As is known to those of ordinary skill in the art, the term "computer storage medium" includes volatile and nonvolatile, removable and non-removable media implemented in any method or technology for storing information (such as computer-readable instructions, data structures, program modules or other data). The computer storage medium includes, but is not limited to, a random access memory (RAM), a read only memory (ROM), an electrically erasable programmable read-only memory (EEPROM), a flash memory, or another memory technology, a compact disc read-only memory (CD-ROM), a digital video disc (DVD) or other optical disc storage, a magnetic cassette, a magnetic tape, disk storage or another magnetic storage apparatus, or any other media used to store the desired information and accessible by a computer. Additionally, as is known to those of ordinary skill in the art, the communication medium generally includes computer-readable instructions, data structures, program modules or other data in modulated data signals such as carriers or other transmission mechanisms, and may include any information delivery medium.

## Claims

1. A power monitoring method, comprising:
detecting a parameter of an internal circuit to be monitored in a power supply, determining a performance-index monitoring value of the internal circuit according to a detection result, and determining a deviation between the performance-index monitoring value and a performance-index standard value; and
determining a state of the internal circuit according to the deviation.

2. The method of claim 1, wherein the internal circuit comprises an input conditioning circuit; and
wherein detecting the parameter of the internal circuit to be monitored in the power supply, calculating the performance-index monitoring value of the internal circuit according to the detection result, and determining the deviation between the performance-index monitoring value and the performance-index standard value comprises:
detecting an input voltage and an output voltage of the input conditioning circuit, calculating a voltage-drop monitoring value of the input conditioning circuit according to a detection result, and determining a deviation between the voltage-drop monitoring value and a voltage-drop standard value.

3. The method of claim 2, wherein detecting the parameter of the internal circuit to be monitored in the power supply further comprises:
detecting at least one of a current of the input conditioning circuit or a temperature of an environment where the input conditioning circuit is located; and
wherein the voltage-drop standard value is determined in a following manner: searching, according to at least one of the detected current or the detected temperature, information about a correspondence between the voltage-drop standard value of the input conditioning circuit and the at least one of the current or the temperature to obtain the voltage-drop standard value.

4. The method of claim 1, wherein the internal circuit comprises a predefined circuit, and the predefined circuit comprises a power conversion circuit; and
wherein detecting the parameter of the internal circuit to be monitored in the power supply, calculating the performance-index monitoring value of the internal circuit according to the detection result, and determining the deviation between the performance-index monitoring value and the performance-index standard value comprises:
detecting an input voltage, an input current, an output voltage and an output current of the predefined circuit, calculating an efficiency monitoring value of the predefined circuit according to a detection result, and determining a deviation between the efficiency monitoring value and an efficiency standard value.

5. The method of claim 4, wherein the efficiency standard value is determined in a following manner: searching, according to at least one of the detected input voltage or a load, information about a correspondence between the efficiency standard value of the predefined circuit and the at least one of the input voltage or the load to obtain the efficiency standard value.

6. The method of claim 1, wherein determining the state of the internal circuit according to the deviation comprises:
in a case where the deviation is a deviation determined for the internal circuit for a first time or the deviation is greater than a basic deviation of the internal circuit, determining the state of the internal circuit by using the deviation, and storing the deviation as the basic deviation of the internal circuit; and
in a case where the deviation is not the deviation determined for the internal circuit for the first time and the deviation is less than or equal to the basic deviation of the internal circuit, maintaining the state of the internal circuit determined by using the basic deviation.

7. The method of claims 1 to 6, wherein determining the state of the internal circuit according to the deviation in at least one of following determination manners:
in a case where the deviation falls into a deviation allowable range corresponding to a normal state, determining that the internal circuit is in the normal state;
in a case where the deviation falls into a deviation alarm range corresponding to an alarm state, determining that the internal circuit is in the alarm state; or
in a case where the deviation falls into a deviation fault range corresponding to a fault state, determining that the internal circuit is in the fault state.

8. The method of claim 7, wherein after determining that the internal circuit is in the alarm state, the method further comprises:
in a case where a system where the power supply is located has a plurality of power supplies for powering, automatically adjusting a current limit point of the power supply downward, and reporting adjustment information about the current limit point to the system.

9. The method of any one of claims 1 to 6, and 8, further comprising:
after acquiring monitoring data, reporting the monitoring data to a system where the power supply is located, wherein the monitoring data comprises information about at least one of the detection result, the performance-index monitoring value, the deviation or the state of the internal circuit.

10. The method of claim 1, wherein detecting the parameter of the internal circuit to be monitored in the power supply comprises:
detecting an associated parameter of the performance-index standard value; and
wherein the performance-index standard value is determined in a following manner: searching, according to a parameter value of the associated parameter obtained by detecting the associated parameter, information about a correspondence between the performance-index standard value and the parameter value of the associated parameter to obtain the performance-index standard value.

11. The method of claim 10, wherein the information about the correspondence is obtained in a following manner: after the power supply is powered up and operates in a system, detecting a performance-index standard value corresponding to the parameter value of the associated parameter, correcting initially stored information about the correspondence according to a detection result, and searching for the performance-index standard value by using the corrected information about the correspondence.

12. A power supply, comprising a monitoring apparatus and an internal circuit to be monitored, wherein the monitoring apparatus comprises:
a parameter detection module, configured to detect a parameter of the internal circuit, and determine a performance-index monitoring value of the internal circuit according to a detection result;
a deviation calculation module, configured to determine a deviation between the performance-index monitoring value and a performance-index standard value; and
a state determination module, configured to determine a state of the internal circuit according to the deviation.

13. The power supply of claim 12, wherein the internal circuit comprises an input conditioning circuit; and
the parameter detection module is configured to detect an input voltage and an output voltage of the input conditioning circuit, and calculate a voltage-drop monitoring value of the input conditioning circuit according to a detection result; and
the deviation calculation module is configured to determine a deviation between the voltage-drop monitoring value and a voltage-drop standard value.

14. The power supply of claim 12, wherein the internal circuit comprises a predefined circuit, and the predefined circuit comprises a power conversion circuit;
the parameter detection module is configured to detect an input voltage, an input current, an output voltage and an output current of the predefined circuit, and calculate an efficiency monitoring value of the predefined circuit according to a detection result; and
the deviation calculation module is configured to determine a deviation between the efficiency monitoring value and an efficiency standard value corresponding to the efficiency monitoring value.

15. The power supply of any one of claims 12 to 14, wherein the state determination module is configured to, in a case where the deviation falls into a deviation alarm range corresponding to an alarm state, determine that the internal circuit is in the alarm state; and
the monitoring apparatus further comprises:
a current-limit-point adjustment module, configured to, after the state determination module determines that the internal circuit is in the alarm state, in a case where a system where the power supply is located has a plurality of power supplies for powering, automatically adjust a current limit point of the power supply downward and report adjustment information about the current limit point to the system.

16. The power supply of any one of claims 12 to 14, wherein the state determination module is configured to:
in a case where the deviation is a deviation determined for the internal circuit for a first time or the deviation is greater than a basic deviation of the internal circuit, determine the state of the internal circuit by using the deviation, and store the deviation as the basic deviation of the internal circuit; and
in a case where the deviation is not the deviation determined for the internal circuit for the first time and the deviation is less than or equal to the basic deviation of the internal circuit, maintain the state of the internal circuit determined by using the basic deviation.

17. A power monitoring apparatus, comprising a memory, a processor and a computer program stored in the memory and executable on the processor, wherein the processor, when executing the computer program, implements the power monitoring method of any one of claims 1 to 11.

18. A computer-readable storage medium, configured to store a computer program, wherein the computer program, when executed by a processor, implements the power monitoring method of any one of claims 1 to 11.
